# EUROPEAN PATENT SPECIFICATION

(11) **EP 4 174 919 B1**
(45) Date of publication and mention of the grant of the patent: **24.06.2026**
(21) Application number: 22204460.4
(22) Date of filing: 28.10.2022
(51) Int. Cl.: H10P 72/00

(54) **SUBSTRATE PROCESSING APPARATUS**
VORRICHTUNG ZUR BEARBEITUNG VON SUBSTRATEN
APPAREIL DE TRAITEMENT DE SUBSTRAT

(30) Priority: 02.11.2021 US 202163274646 P
(43) Date of publication of application: 03.05.2023
(73) Proprietor: ASM IP Holding B.V., 1322 AP Almere (NL)
(72) Inventor: OOSTERLAKEN, Theodorus G.M., 1322 AP Almere (NL)
(74) Representative: V.O.

(56) References cited:
- JP-A- S5 648 128
- US-A1- 2003 075 536
- US-A1- 2009 291 566
- US-A1- 2013 125 797
- US-A1- 2020 168 486
- US-B1- 6 228 174
- US-B1- 6 352 593

## Description

### Technical Field of the Disclosure

The present disclosure relates to the field of semiconductor device fabrication. More specifically, it relates to a substrate processing apparatus. It further relates to a method of forming a semiconductor structure therefrom.

### Background of the Disclosure

The semiconductor industry is faced with more requirements in terms of manufacturing as device scaling continues. As wafer sizes are increasing in order to increase the number of chips produced per wafer, the need for reducing cost, for economic use of cleanroom space also steps forward.

Utilization of batch processing tools may be a way to move forward in this regard. This is due to the fact that batch processing tools are capable of handling a plurality of wafers at the same time. However, they may present other challenges associated with their use that can influence the reliability of the wafers processed therein, yield of the process itself and the throughput obtained in a much larger scale. To enable large-scale cost-efficient wafer processing in batch tools, attempts have been made to change their designs.

US2013/0125797A1 discloses a vertical heat treatment furnace having the features of the pre-characterizing portion of claim 1 except for the plurality of cooling outlets. As described therein, immediately after the reaction in the reaction chamber is finalized, a fast cooling process is performed (see [0039]). To effect the fast cooling, cooling nitrogen is introduced into the reaction chamber - comparable to the claimed feature "process space" - and the gas circulation chamber, which latter is comparable to the claimed feature of the "interior space/cooling channel". This is done after the reaction. Cooling gas is introduced simultaneously inside the process space and the interior space so that the two walls (the inner and the outer wall) of the inner body - comparable to the claimed feature "inner enclosure" - are cooled down simultaneously to increase the cooling rate and to reduce the concern of chipping or peeling (see [0039]). Thus, according to US'797 a fast cooling process is obtained, whereby fast is a cooling time of "only 120 minutes" (see par. [0040]).

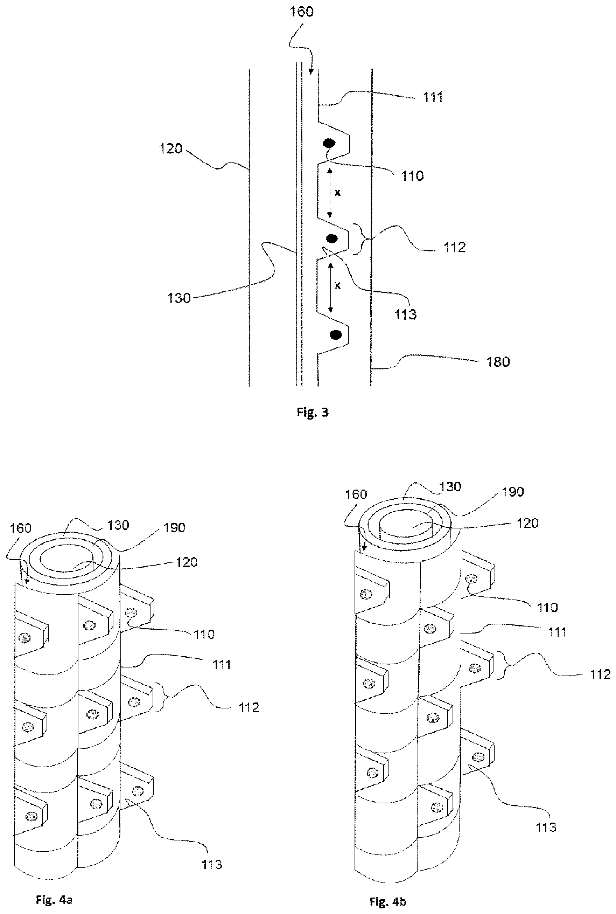

US2009/0291566A1 discloses a vertical furnace according to the pre-characterizing portion of claim 1 including the plurality of cooling outlets. There the cooling air passage 61, which is comparable with the claimed feature of "interior space" or "cooling channel" has only one cooling air inlet 62 near the lower part thereof and multiple sub-exhaust ports 65 at the top of the cooling air passage 61 to allow efficiently exhausting the cooling air passage without being in the way for the installation of ceiling heating lamps (see [0077] and [0078] and Fig. 3 of US'566).

Although considerable progress has been made in processing with batch tools, it may still be challenging to provide batch processing tools, particularly vertical ones, with reduced depositions occurring on the inner walls of the process space.

There is, therefore, a need in the art to provide an improved vertical furnace for wafer processing.

### Summary of the Disclosure

It is an object of the present disclosure to provide a batch processing apparatus having improved deposition characteristics. More specifically, it may be an objective to provide a vertical furnace allowing for deposition on substrates, whereby deposition on the walls of an inner enclosure, and particularly, on the walls of the inner enclosure facing the wafer boat, can be reduced. To at least partially achieve this goal, the present disclosure may provide a vertical furnace and a method for forming a semiconductor structure as defined in the independent claims. Further embodiments of the vertical furnace and the method are provided in the dependent claims.

In a first aspect, the present disclosure relates to a vertical furnace. This vertical furnace may comprise an inner enclosure defining a process space and an opening. This process space may extend in a vertical direction and the opening may be for receiving a plurality of wafers. This vertical furnace may comprise an outer enclosure that may surround the inner enclosure. Furthermore, it may comprise a gas injector for injecting a process gas into the process space. It may also comprise an exhaust gas outlet for exhausting the process space. This vertical furnace may be provided with a lamp for heating the plurality of wafers. This lamp may be arranged circumferentially in an interior space between the inner enclosure and the outer enclosure. This vertical furnace may further comprise a cooling inlet for providing a cooling fluid into the interior space to cool the interior space.

The inventive vertical furnace according to the first aspect may allow for keeping the walls of the inner enclosure at a lower temperature than that of the process space thanks to the cooling fluid provided in the interior space. This may have the advantage of reducing undesirable processes such as, for example, depositions from occurring on the walls of the inner enclosure and particularly on the walls of the inner enclosure facing the wafer boat. Reduced depositions may thus, reduce the downtime of this vertical furnace since the number of maintenance cycles may be reduced.

It may be an advantage of embodiments of the first aspect that the temperature of the interior space may be kept at a lower temperature thanks to the cooling fluid provided therein.

It may be an advantage of embodiments of the first aspect that it may provide one heating system for a plurality of wafers. This may allow for optimization of the cost of manufacturing and may further allow for setting the thermal budget of the process in an economical way.

It may be an advantage of embodiments of the first aspect that it also allows for processing at lower temperatures. This may have the advantage that it reduces issues regarding stress relaxation in deposited films. Stress relaxation can give rise to increased warpage of the wafers, peeling or delamination of the films, thereby leading to particle contamination in the vertical furnace.

It may be an advantage of embodiments of the first aspect that more economic wafer processing may be achieved. This may be due to the fact that films can deposited on a plurality of substrates in this vertical furnace, thereby reducing cost of wafer processing.

It may be an advantage of embodiments of the first aspect that the process gas may be provided in order to process a plurality of wafers at a time, thereby increasing throughput of the process.

It may still be further an advantage of embodiments of the first aspect that the throughput of wafer processing in this vertical furnace may be increased. This may also be due to the fact that processing done on a plurality of substrates in this vertical furnace leads to more wafers to be processed in a given amount of processing time.

It may be an advantage of embodiments of the first aspect that yield of wafer processing in this vertical furnace may be increased thanks to the issues regarding such as, for example, stress relaxation, variation in the thickness of the deposited film over a wafer or over the plurality of wafers being reduced.

In a second aspect, the present disclosure relates to a method of forming a semiconductor structure comprising a film. This method may comprise providing a plurality of wafers that may be arranged in a wafer boat. This wafer boat may be loaded into a process chamber of a vertical furnace according to embodiments of the first aspect. The method may further comprise heating the process space, thereby increasing the temperature up to a predetermined temperature suitable for forming a film. A process gas may be provided into the process space. This process gas may be suitable for forming the film on the plurality of wafers at the predetermined temperature. Thereafter, a cooling fluid may be provided in the interior space for cooling the interior space.

It may be an advantage of embodiments of the second aspect that the walls of the inner enclosure may be kept at a lower temperature than that of the process space thanks to the provision of the cooling fluid provided in the interior space. This may allow to avoid undesirable processes such as, for example, depositions from occurring on the walls of the inner enclosure of this vertical furnace, and particularly on the walls facing the wafer boat.

It may be an advantage of embodiments of the second aspect that it may allow for processing a plurality of substrates also at lower temperatures. This may be advantageous for providing reduced stress relaxation of films provided on the plurality of substrates. This in turn may increase yield of processing in this vertical furnace.

Although continuing development has been taking place in this field, the present concepts are believed to represent substantial new developments. Departures from prior art practices are included in the present concepts that result in improved vertical furnaces.

The above and other characteristics, features and advantages of the present disclosure will become apparent from the following detailed description to be considered together with the drawings included. The drawings illustrate, by way of example, the principles of the disclosure. This description is given for the sake of example only, without limiting the scope of the disclosure. The reference figures referred to below relate to the drawings included.

Particular and preferred aspects of the disclosure are set out in the accompanying independent and dependent claims. Features from the dependent claims may be combined with features of the independent claims. Features from the dependent claims may be combined with features of other dependent claims as appropriate and not as just set out in the claims.

### Brief Description of the Figures

The above, as well as additional objects, features and advantages of the present inventive concept, will be better understood through the following illustrative and non-limiting detailed description. Reference is also made to the drawings included. Like reference numbers will be used for like elements in the drawings unless stated otherwise.
Fig.1: is a schematic top view of a vertical furnace according to embodiments of the first aspect of the present disclosure.
Fig.2: is a schematic cross-section of a vertical furnace provided with a lamp according to embodiments of the first aspect of the present disclosure.
Fig. 3: is a schematic cross-section of a vertical furnace comprising a plurality of lamps according to embodiments of the first aspect of the present disclosure.
Fig.4a to Fig.4c: show schematically a tilted view of a reflector assembly according to embodiments of the first aspect of the present disclosure.
Figs. 5a and 5b: shows two sets of simulation results (A, B) of coupling of the optimal heat into a vertical furnace according to embodiments of the first aspect of the present disclosure - 5aTemperature (°C) of wafer and Temperature (°C) of inner enclosure as a function of lamp temperature (°C) (closed circles - temperature of wafer stack and closed triangles - temperature of the inner enclosure) and 5b power usage (kW) as a function of wafer temperature obtained as a result of simulation with lamps for different vertical furnace configurations (1,2).
Fig. 6: shows a flowchart of an exemplary method according to embodiments of the second aspect of the present disclosure.

### Detailed Description of the Disclosure

The present disclosure will be described with respect to particular embodiments and with reference to certain drawings. However, the disclosure is not limited thereto but only by the claims. The drawings described are only schematic and are non-limiting. The dimensions do not correspond to actual reductions to practice the disclosure. The size of some of the elements may not be drawn to scale, in the drawings, for illustrative purposes.

It is to be noticed that the term "comprising", used in the claims, should not be interpreted as being restricted to the means listed thereafter. It does not exclude other elements or steps. It is thus, to be interpreted as specifying the presence of the stated features, steps or components as referred to. However, it does not prevent one or more other steps, components, or features, or groups thereof from being present or being added.

Reference throughout the specification to "embodiments" in various places throughout the specification are not necessarily all referring to the same embodiment, but may. Furthermore, the particular features, structures or characteristics maybe combined in any suitable manner, as would be apparent to one of the ordinary skill in the art from the disclosure, in one or more embodiments.

It should be understood that in the description of exemplary embodiments of the disclosure, various features of the disclosure are sometimes grouped together in a single embodiment, figure or description in order to help to understand one or more of the inventive aspects. The claims following the detailed description are incorporated into the detailed description, with each claim standing on its own as a separate embodiment of the disclosure.

Some embodiments described herein include some, but not other features included in other embodiments. However, combinations of features of different embodiments are meant to be within the scope of the disclosure, and form different embodiments, as would be understood by those in the art. In the claims included, any of the claimed embodiments can, for example, be used in any combination.

The following terms are provided only to help in the understanding of the disclosure.

As used herein and unless provided otherwise, the term "pitch value of lamps" refers to the sum of the diameter of one of the lamps and the spacing between that lamp and an adjacent one.

As used herein and unless provided otherwise, the term "base width of pockets" refers to the distance between the two points of the pockets connect the partially non-reflective portion of the reflector assembly with the reflective portion.

As used herein and unless provided otherwise, the term "height of pockets" refers to the distance measured from a highest point of a pocket extending to a point intersecting an axis defining the partially non-reflective portion of the reflector assembly.

As used herein and unless provided otherwise, the term "interior space" refers to the volume of space between the inner enclosure and the outer enclosure comprised in the vertical furnace.

As used herein and unless provided otherwise, the term "system configuration" refers to the configuration of the lamps together with the configuration of the cooling provided.

As used herein, reference to "each" of a particular element (e.g., "each of the cooling gas inlets", "each of the plurality of lamps", "each of the pockets") may refer to two or more of the elements, and may not refer to every one of the elements. For example, "each of the cooling gas inlets" may refer to individual cooling gas inlets comprised in a plurality of cooling gas inlets and it need not necessarily refer all cooling gas inlets.

As used herein, reference to "a vertical direction" represents the direction along a vertical axis.

The disclosure will now be described by a detailed description of several embodiments of the disclosure. It is clear that other embodiments of the disclosure can be configured according to the knowledge of persons skilled in the art without departing from the technical teaching of the disclosure, the disclosure being limited only by the terms of the claims included.

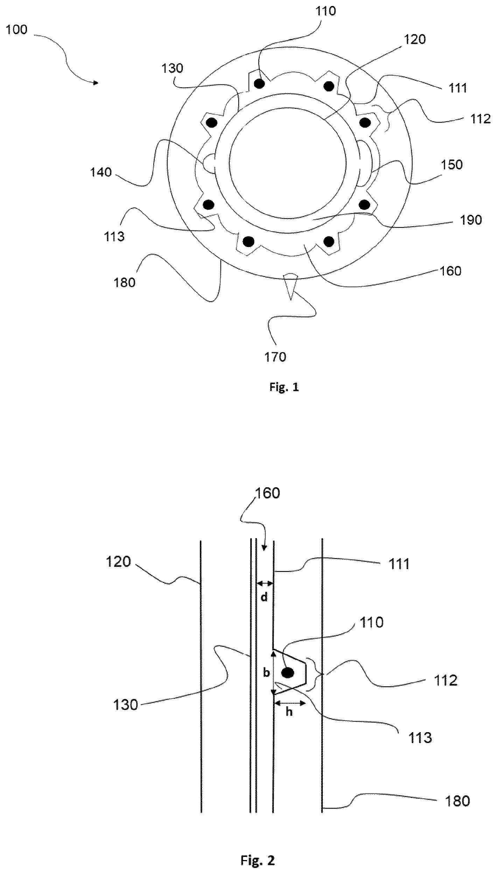

A schematic top view of a vertical furnace according to embodiments of the first aspect of the present disclosure is shown in Fig. 1.

Fig. 2 shows a schematic cross section of the vertical furnace according to embodiments of the first aspect of the present disclosure.

This vertical furnace may comprise an inner enclosure (130) defining a process space (190) and an opening (not shown in the figures). This process space (190) may extend in a vertical direction and the opening may be for receiving a plurality of wafers. In embodiments, the plurality of wafers may be arranged in a wafer boat (120). In embodiments, inner walls of the inner enclosure (190) may face the wafer boat. In embodiments, the wall thickness of the inner enclosure may be in a range of 3 mm to 10 mm. In preferred embodiments, it may be in a range of 5 mm to 6 mm. In embodiments, the inner enclosure (130) may have a diameter in the range of 350 mm to 430 mm. This vertical furnace may also comprise an outer enclosure (180). This outer enclosure (180) may surround the inner enclosure (130). In embodiments, the outer enclosure (180) may have a diameter in the range of 480 mm to 630 mm.

A gas injector (not shown in the figures) may also be comprised in this vertical furnace for injecting a process gas into the process space (190). In embodiments, the gas injector may be placed in the process space (190). A gas inlet (140) may be present, in embodiments, in order to provide the process gas to the gas injector. Upon reaching the gas injector, the process gas may then be provided into the process space (190) by this gas injector.

This vertical furnace further may comprise an exhaust gas outlet (150) for exhausting the process space. The exhaust gas, in embodiments, may comprise unreacted process gas and/or gases produced as a result of the contact of the process gas with the plurality of wafers. This vertical furnace may be provided with a lamp (110) for heating the plurality of wafers (Fig. 2). In embodiments, this lamp may, for example, be a halogen lamp. This lamp (110) may be arranged circumferentially in an interior space. This interior space may be positioned between the inner enclosure (130) and the outer enclosure (180). This vertical furnace may further comprise a cooling inlet (not shown in the figures) for providing a cooling fluid into the interior space to cool the interior space. In embodiments, the cooling fluid may be provided into the interior space such that its flow direction may be directed to be through the cooling channel (160), thereby cooling the interior space. The cooling of the interior space may provide the advantage that the inner walls of the inner enclosure (130) may be kept at a lower temperature than that of the process space (190). This may be as a result of the heat transfer occurring on the outer walls of the inner enclosure (130) thanks to the cooling effect provided on the outer walls due to the flow of the cooling fluid in the cooling channel (160). This may allow to avoid undesirable processes such as, for example, depositions or particle contamination from occurring on the inner walls of the inner enclosure (130) of this vertical furnace due to the lower temperature of the inner walls compared to that of the process space (190).

This vertical furnace may, in embodiments, be a furnace for carrying out processes such as, for example, oxidation, film deposition or diffusion. This vertical furnace may, in embodiments, be an epitaxial deposition tool for depositing epitaxial layers. Therefore, such a vertical furnace may be advantageously used for epitaxial depositions to provide a faster process with lower manufacturing cost.

In embodiments, the cooling fluid may be a liquid or a gas. In embodiments, this liquid may comprise a liquid mixture suitable for cooling. In preferred embodiments, this cooling fluid may be a gas. Thus, this cooling gas may, for example, be air, nitrogen gas or carbon dioxide gas. In yet preferred embodiments, this gas may be air. In embodiments, this cooling gas may be provided at a temperature in a range of 10 °C to 150 °C. In preferred embodiments, it may be provided at a temperature in a range of 20 °C to 50 °C. The flowrate of this cooling gas may be configured such that a faster heat transfer can occur between the inner enclosure and the partially non-reflective portion so that faster cooling of the inner enclosure (130) in a minimum amount of time can be enabled. The cooling may thus, be occurring on the outer walls of the inner enclosure (130). The flow rate may, in embodiments, be for example, in the range of 200 m³/hour to 2000 m³/hour. In embodiments, the flow rate of cooling gas may be about 500 m³/hour.

It is to be understood that in alternative embodiments, this cooling gas may also comprise a gas mixture suitable for cooling.

In embodiments, the vertical furnace may comprise a plurality of cooling inlets (not shown in the figures) for providing the cooling fluid. This may allow for distributing the cooling gas evenly within the interior space. This may provide a balanced cooling effect circumferentially around the inner enclosure (130). Due to the cooling effect provided by the cooling fluid, heat conduction is enhanced, thereby decreasing the temperature on the inner walls of the inner enclosure (130). The plurality of cooling inlets may, in embodiments, be located at an upper portion of the vertical furnace so that the flow of the cooling fluid can be directed evenly within the cooling channel (160) from an upper end to a lower end of the vertical furnace along its vertical axis. The cooling gas may be provided to the vertical furnace through a main cooling gas inlet. Further on, through this main cooling gas inlet, the cooling gas may further be distributed into each of the cooling gas inlets.

In alternative embodiments, the plurality of cooling inlets may be configured such that they may be positioned collinear along the vertical direction of the vertical furnace so that upon entry of the cooling fluid in the cooling channel (160) through each of these cooling inlets, the cooling fluid travels circumferentially in the cooling channel (160) before leaving the cooling channel through the cooling outlets. The cooling outlets may, in these embodiments, be aligned adjacent to the cooling inlets. In these embodiments, the cooling fluid may preferentially be a cooling gas. In these embodiments, the cooling gas may be provided with a pre-determined pressure value in order to keep it rotating around the circumference through a trajectory before exiting the cooling channel (160) through the cooling outlets. These embodiments may offer the advantage of coping with issues that may relate to the cooling of the plurality of lamps. These embodiments may further provide the advantage of protecting electrical and/or mechanical connection points of the plurality of the lamps.

In yet alternative embodiments, the plurality of cooling inlets may be configured such that they may be positioned diagonally to one another along the vertical direction of the vertical furnace so that upon entry of the cooling fluid in the cooling channel through each of the cooling inlets, the cooling fluid travels circumferentially in the cooling channel (160) before leaving the cooling channel through a plurality of cooling outlets. In these embodiments, the cooling outlets may also be aligned adjacent to the cooling inlets. These embodiments may offer the advantage of coping with issues that may relate to the cooling of the plurality of lamps. These embodiments may further provide the advantage of protecting electrical and/or mechanical connection points of the plurality of the lamps.

It is to be understood that in embodiments, where the cooling inlets may be positioned collinear or diagonally along the vertical direction, the spacing of the cooling inlets and the flowrate of the cooling gas provided through these cooling inlets may be configured such that the desired cooling effect can be achieved, so that deposition on the inner walls of the inner enclosure (130) can be reduced.

In embodiments, the vertical furnace may comprise a plurality of lamps (110) for heating the plurality of wafers that may be arranged circumferentially in the interior space. This may allow for the provision of a balanced distribution of heat circumferentially in the interior space. Balanced distribution of heat may overcome the variation in the process characteristics across the wafer, such as for example thickness variation of deposited films, dopant distribution in the deposited films or gap fill characteristics. This is because process characteristics are typically temperature driven and variation in temperature across the wafer surface can lead to such differences.

In embodiments, the plurality of lamps (110) may have a pitch value in the range of 10 cm to 25 cm along the vertical direction. This may result in a balanced distribution of the plurality of lamps (110) along the vertical direction. It is to be understood that depending on the size of the lamps (110) and how hot they can become, the pitch value can then further be adjusted in order to provide as much heat as possible to the process space (190), thereby heating the wafers in the wafer boat sufficiently. If bigger size lamps are to be used, they may then be spaced apart with a specific pitch value. Since the wafer boat may be rotated, temperature can be evened-out, thereby profiting from the heat provided by these lamps. A pitch value being smaller than this range may require the lamps to be smaller in size. This may, therefore, lead to the fact that lamps may get vulnerable. A pitch value being larger than this range may have an influence on the uniformity across the wafers in the wafer boat. Fig. 3 shows a schematic cross-section of a vertical furnace comprising a plurality of lamps (110). In embodiments, the plurality of lamps (110) may be positioned at regular intervals from one another circumferentially and they may be extending along the vertical direction. Being positioned at regular intervals circumferentially from one another may have the advantage that the wafers can be subjected to a uniform heat exposure. In embodiments, the plurality of lamps may be extending at regular intervals (X) from one another along the vertical direction. This may contribute to the provision of the balanced distribution of heat along the vertical direction. In this way, the plurality of lamps (110) may serve the plurality of wafers in one go in terms of providing heat. This may be advantageous since it may provide a balanced distribution of heat along the vertical direction of this vertical furnace. Balanced distribution of heat along the vertical direction may allow for overcoming wafer-to-wafer process variations within the wafer boat. These wafer-to-wafer variations may, for example, be thickness variation of deposited films, dopant distribution in the deposited films or gap fill characteristics. This may be advantageous since wafer-to-wafer variations within the wafer boat may lead to reduction in the yield of the process executed in this vertical furnace. Furthermore, it may result in an increase in manufacturing costs since some of the wafers would not meet the process specifications.

In embodiments, this vertical furnace may further comprise a reflector assembly arranged within the interior space in a vertical direction and may be formed in a cylindrical shape enclosing the process space (190). The reflector assembly may comprise a reflective portion (113) (Fig. 2) alternatingly arranged with a partially non-reflecting portion (111). In embodiments, this reflector assembly may extend along a height corresponding to the height of the process space (190). The plurality of wafers may be arranged in the wafer boat, which can fit the process space. Therefore, the reflector assembly with its height corresponding to the height of the process space (190) may allow for providing the required heat, to the plurality of wafers, necessary for the processing and for keeping the inner walls of the inner enclosure (130) cool enough for minimizing deposition thereon.

This reflective portion (113) may be formed as pockets (112) protruding from the partially non-reflective portion (111) and may be extending away from the inner enclosure (130). Each of the plurality of lamps (110) may be positioned individually inside each of the pockets (112). These pockets (112) may, in embodiments, be also referred to recessing from the partially non-reflective portion (111) and may be extending away from the inner enclosure (130). It may be advantageous to have the partially non-reflecting portion (111) since in this way the desired heating efficiency by the lamps may be provided.

In embodiments, the protruding pockets (112) may have square, semi-circular, parabolic, triangular, or trapezoidal shape. The protruding pockets (112) having these shapes may surround the lamps positioned inside them in such a way that sufficient ray of light may be obtained. Furthermore, these shapes may help channeling the heat towards the wafer boat (120). Due to the presence of the plurality of these pockets (112), a balanced heat exposure can be provided towards the wafer boat (120). In embodiments, these protruding pockets (112) may have a base width in the range of 50 mm to 70 mm. In embodiments, these protruding pockets (112) may have a height in the range of 30 mm to 60 mm. Considering the fact that the size of the lamps for heating may be in a range between 14 nm to 15 nm, the base width and the height of the protruding pockets (112) provided in the given ranges may be sufficient for providing the required heat. It is to be understood that depending on the size of the lamp to be used, the base width and the height of the protruding pockets (112) may further be configured. Thus, in embodiments, the base width and the height of these protruding pockets (112) may be configured such that it is small enough so that the lamps are robust when placed in these pockets and maybe configured such that it is large enough so that uniformity across the wafers is not challenged.

In embodiments, the reflective portion (113) may comprise a reflector facing the lamp (110). This may have the advantage of providing efficient heat transfer on the inner enclosure (130) by allowing complete reflection inside the pockets (112). Complete reflection inside the pockets (112) may lead to obtaining a lower temperature to be obtained at the outer walls of the inner enclosure (130). This reflector may, in embodiments comprise a silver alloy or an aluminium alloy. This silver alloy, in embodiments, may be such that it can preserve its ability to reflect radiant energy. This may allow that the efficiency of the reflector does not diminish over time. This silver alloy, in embodiments, may comprise constituents such that it can be susceptible to manufacturing so that its lifetime would not be shortened. This aluminium alloy, in embodiments, may be such that it can be resistant to oxidation so that the associated reflectivity would not change, thereby not jeopardizing its functionality. In embodiments, this silver alloy or aluminium alloy may be provided in the form of a coating that may be provided on the reflector. This may provide easy replacement or lead to a possibility of re-coating should there be such as, for example, wear problems associated with it. This may have the advantage of providing an economical process and reduced downtime of the vertical furnace.

In embodiments, the partially non-reflective portion (111) of the reflector assembly may be positioned away from the inner enclosure (130) by a distance (d) in the range of 10 mm to 40 mm, thereby forming a passage (160) for cooling the inner enclosure (130) by flowing the cooling fluid. This distance (d) being in this range may be advantageous in order to provide the required cooling effect on the walls of the inner enclosure (130) since with the increase in the value of this distance (d), the walls of the inner enclosure may get hotter. Therefore, this distance (d) may be the minimal distance required for providing this kind of a cooling effect. When such cooling effect is provided, the probability of having undesirable film depositions or particle contamination on the walls of the inner enclosure (130) may be reduced. On the other hand, smaller values for this distance (d) may lead to the power usage becoming higher. Therefore, the flow rate of the cooling gas provided into the cooling channel (160) and the distance (d) may, together, provide the advantage of leading to an efficient cooling of the walls of the inner enclosure (130) while providing an economical energy consumption. The distance (d) may be measured from a point in between any two neighboring protruding pockets (112), thus, from any point on the partially non-reflective portion (111) extending along a second axis to a point on the inner enclosure (130), the second axis being perpendicular to the vertical direction. The surface area of the partially non-reflective portion (111) of the reflector assembly may be configured such that the heat loss over this portion is kept to a minimum, such as for example 5Kw/m2 for a wafer temperature of 600 °C, so that the heat provided by the plurality of lamps (110) can still be sufficient to keep a uniform temperature in the process space (190) to carry out the desired substrate processing. It may, therefore, be advantageous that the plurality of lamps (110) become as hot as possible, thereby providing as much heat as possible. In this way, while cooling effect is being provided by the cooling fluid flowing in the cooling channel (160), the lamps can still provide the necessary temperature to carry out the required processing in the process space (190) on the plurality of wafers arranged in the wafer boat (120).

Fig.4a to Fig.4c show schematically a tilted view of a reflector assembly according to embodiments of the first aspect of the present disclosure. The plurality of lamps (110) schematically represented in these figures may, in embodiments, be connected to a single power supply in order to turn them on. In alternative embodiments, each of the plurality of lamps (110) represented in these figures may be separately turned on or off. This may have the advantage that individual lamps may be turned on or turned off as required depending on the wafer load in the wafer boat or the process temperature required for processing in the process space (190). In embodiments, the plurality of lamps (110) may be positioned collinear to one another along the vertical direction, as schematically represented in Fig. 4a. In addition to being positioned collinear in a vertical direction, the plurality of lamps may, in these embodiments, also be collinear circumferentially. This may mean that they may be aligned along a plurality of parallel circumferential axis that are perpendicular to the vertical direction. This may, in other words, infer that the plurality of lamps is positioned at 90° with the vertical direction. It is to be understood that the spacing between the plurality of lamps (110) in the vertical direction may be the same or may differ from the spacing between the plurality of lamps (110) along the plurality of parallel circumferential axis. This kind of configuration of the plurality of lamps (110) may provide the advantage of a balanced and an equal heat flux provided by each of the plurality of lamps (110) to the process space (190) for processing the wafers arranged in the wafer boat (120). Balanced and equal distribution of heat may overcome the variation in the process characteristics across the wafer, such as for example thickness variation of deposited films, dopant distribution in the deposited films or gap fill characteristics. This is because process characteristics are typically temperature driven and variation in temperature across the wafer surface can lead to such differences.

It is to be understood that in alternative embodiments, the functioning of the plurality of lamps (110) may be configured such that the number of functional lamps circumferentially positioned from one another may be different along the vertical axis, so that a balanced heat flux may be obtained.

In embodiments, as schematically represented in Fig. 4a, this may indicate turning on different numbers of lamps in each row that is aligned along the plurality of parallel circumferential axis, while keeping others in the off state. This may further provide the advantage of tuning the number of functional lamps according to the wafer load in the wafer boat and/or the heat flux required to carry out the desired wafer processing. This may further provide the advantage of adjusting the power consumption as a function of the different wafer processing.

In embodiments, the plurality of lamps (110) may be positioned in a staggered order along the vertical direction as schematically represented in Fig. 4b. This may indicate that the plurality of lamps (110) aligned collinear along the vertical direction may be positioned in a shifted manner with respect to one another in terms of alignment along the plurality of parallel circumferential axis. The positioning in the staggered order may provide the advantage of minimizing uniformity effects across the wafers. This may be due to the crossing of the radiation flux of the lamps, which follow a Gaussian distribution along the length and along the width of the lamps.

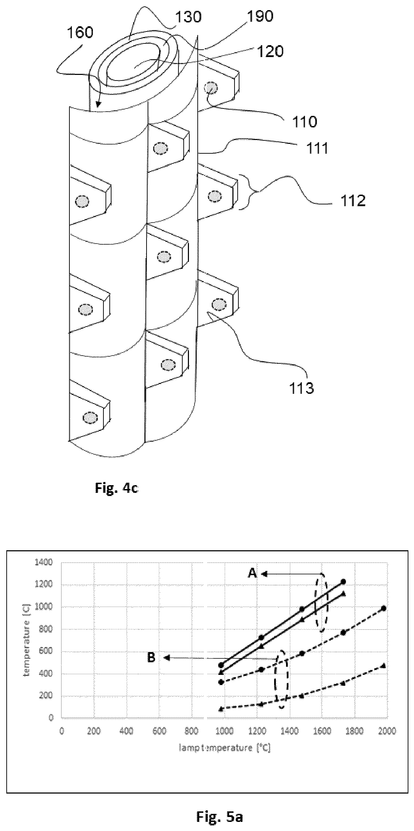

In embodiments, the plurality of lamps (110) may also be positioned diagonally to one another along the vertical direction as schematically represented in Fig. 4c. This may mean that the plurality of lamps may be positioned such that they appear to be spiraling down the vertical direction.

In embodiments, the plurality of lamps may be positioned diagonally at an angle of 15° to 90° to the vertical direction. In alternative embodiments, the plurality of lamps may be positioned diagonally at an angle of 30° to 60° to the vertical direction. This may provide the making of user-friendly electrical connections, thereby facilitating easier functionalization of the lamps. Furthermore, this kind of positioning of the lamps may be advantageous in terms of minimizing uniformity effects across the wafers.

It is to be understood that the configuration of the plurality of lamps as schematically represented in Fig. 4b and Fig. 4c may also be obtained by providing a configuration as schematically represented in Fig. 4a and then by defunctionalizing some of the lamps so that the staggered order (Fig. 4b) or the diagonal positioning (Fig. 4c) can be eventually achieved. In embodiments, where each of the plurality of lamps (110) may be separately connected to a power supply, such defunctionalizing, when required, may easily be done on a configuration as schematically presented in Fig. 4a, thereby obtaining the configurations schematically presented in Fig. 4b or Fig. 4c.

In embodiments, the vertical furnace may comprise means for measuring temperature of the interior space (190), being positioned in a vertical direction along a height corresponding to the height of the process space. Such a configuration may provide the advantage of accurate temperature measurement also along the height of the wafer boat (120) provided in the process space (190), in which the plurality of wafers may be arranged.

The means for measuring temperature, in embodiments, may include thermocouples, infrared sensors, change-of-state sensors, resistive temperature measuring devices or pyrometers, also known as thermal imagers. In embodiments, the means for measuring temperature may comprise a plurality of pyrometers. The presence of plurality of pyrometers have the advantage of providing accurate temperature monitoring in the vertical direction along the height of the process space (190). As the processes taking place in a furnace are typically temperature-driven, accurate temperature control and monitoring may thus, increase the yield of the process. Increased yield may result in reduction in manufacturing costs.

Fig.5a shows an example of coupling of the optimal heat into a vertical furnace obtained by two sets of simulation results (A,B) according to embodiments of the first aspect of the present disclosure. The simulation is performed based on a single wafer with repeated boundary conditions, thereby representing a stack of wafers arranged in a wafer boat. In the case simulated in B, the reflector assembly has been brought closer to the outer wall of the inner enclosure, thereby adjusting the distance (d). Furthermore, pockets protruding from the partially non-reflective portion are foreseen in order to accommodate the lamps. Two different sets of simulations are performed, each having a different parameter set. The temperature of the inner enclosure (130) and the temperature of the wafer stack arranged in the wafer boat (120) is presented as a function of lamp (110) temperature.

It is observed that the temperature of both the wafer stack (120) and the inner enclosure (130) increases as a function of the increase in lamp temperature in both of the simulated cases (A, B). Furthermore, it is observed that a different set of design parameters, going from case A to case B, further provides to obtain a larger temperature difference between the inner enclosure (130) and the wafer stack (120). The larger temperature difference observed between the inner enclosure (130) and the wafer stack (120) may be more beneficial in providing a more efficient cooling effect due to the enhanced heat transfer. This may further indicate the advantageous cooling effect provided by the cooling fluid since the temperature of the inner enclosure (130) is lower than that obtained on the wafer stack (120). The difference observed between the temperature of the inner enclosure (130) and the wafer stack (120), the prior being smaller than the latter, may be an indication that the wafer stack (120) can get hot enough so that the desired process can take place in the process space (190), while the wall of the inner enclosure (130) can be at low enough temperature, thanks to the cooling effect. This may provide the advantageous effect of reducing deposition or particle contamination on the inner walls of the inner enclosure (130). This temperature difference between the temperature of the inner enclosure (130) and the wafer stack (120) may, in embodiments, be in the range of 200 °C to 550 °C to achieve this advantageous effect. In embodiments, this temperature difference between the temperature of the inner enclosure (130) and the wafer stack (120) may be in the range of 200 °C to 300 °C. This may provide further advantage that efficient power usage can be obtained. This may then play a role on improving manufacturing costs.

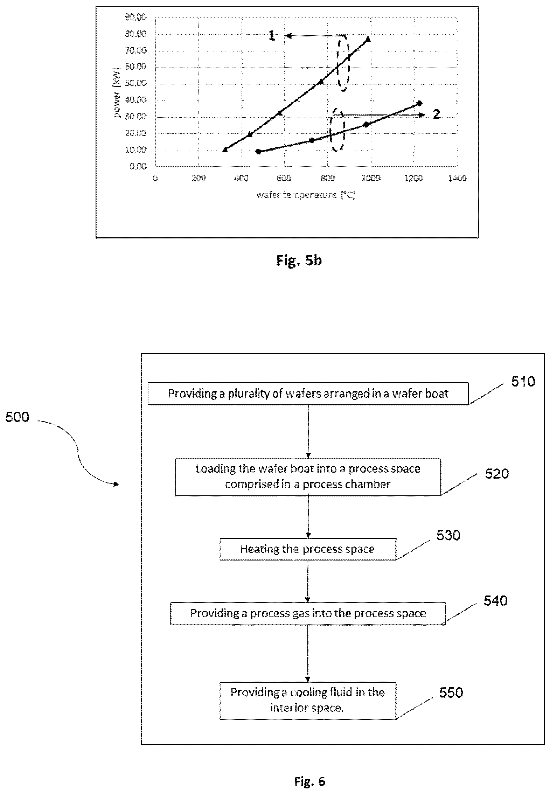

Fig. 5b shows an example of power usage (kW) as a function of wafer temperature obtained as a result of simulation of using lamps with different vertical furnace configurations (1,2). In configuration 1, lamps are present in the absence of the reflector assembly, while configuration 2 is similar to what is represented schematically in Fig. 1. It represents the power that is provided by the lamps as a function of the wafer temperature. It is observed that as the required wafer temperature is increased, the power provided by the lamps is also increased. This result may further indicate the importance in the selection of the lamps. While the power obtainable from the lamps increases as the wafer temperature is increased, it is to be understood that the energy efficiency of the wafer processing can still be tuned by the right choice of the lamps and/or depending on system . It is to be understood that the choice of the lamps and/or system configuration may, in turn, have an influence on the throughput of the wafer processing. This may be due to the fact that the provision of a higher power value at a given wafer temperature may have an influence on increasing throughput. By lamp configuration, it may be understood how the lamps are configured in the vertical furnace. This may indicate their presence and position with respect to the reflector assembly. By cooling configuration, it may be understood how the cooling channel is designed, what the cooling fluid is and what the flowrate of the cooling fluid through the cooling channel is.

Fig. 6 shows a flowchart of an exemplary method according to embodiments of the second aspect of the present disclosure that may be carried out in a vertical furnace according to embodiments of the first aspect of the present disclosure.

The method (500) of forming a semiconductor structure comprising a film may comprise providing (510) a plurality of wafers arranged in a wafer boat. This wafer boat may be loaded (520) into a process space (190) comprised in a process chamber of a vertical furnace according to embodiments of the first aspect. The process space (190) may be heated (530), thereby increasing the temperature up to a pre-determined temperature suitable for forming a film. It is to be understood that the pre-determined temperature may be set to be increased according to the needs of the processing to be carried out in the vertical furnace and/or to the type of the film to be formed. In embodiments, this film may be an oxide, a nitride, or may comprise a semiconductor material. In embodiments, this oxide may be an insulating oxide or a metallic oxide. In embodiments, this nitride may be a silicon nitride or a metal nitride. In embodiments, the semiconductor material may be a Group IV semiconductor material or a Group III-V semiconductor material. In embodiments, the film may be an epitaxial layer. A process gas may be provided (540) in the process space (190) for forming the film on the plurality of wafers at the pre-determined temperature. Thereafter, a cooling fluid may be provided (550) in the interior space for cooling the interior space. In embodiments, the process gas may be provided to the process space (190) by a gas injector that may be comprised in this vertical furnace. The gas injector may extend in a vertical direction within the process space (190).

Inner walls of the inner enclosure (130) may, in embodiments, face the wafer boat (120), while outer walls of the inner enclosure (130) may face the reflector assembly.

It may be an advantage that the inner walls of the inner enclosure (130) that face the wafer boat can be kept at a lower temperature than that of the process space (190) thanks to the cooling effect achieved by the cooling fluid provided in the interior space. This may allow for avoiding undesirable processes such as, for example, depositions or particle contamination from occurring on the inner walls of the inner enclosure (130). When such undesirable processes are avoided, number of maintenance cycles of the vertical furnace may be decreased, thereby also decreasing the downtime of the vertical furnace. Decrease in the number of maintenance cycles may also be an indication of an increase in the time between consecutive maintenance cycles. The interior space is the volume of space between the inner enclosure (130) and the outer enclosure (180) comprised in the vertical furnace. The inner enclosure (130) may define the process space (190).

In embodiments, the cooling fluid may be a liquid or a gas. In embodiments, this liquid may comprise a liquid mixture suitable for cooling. In preferred embodiments, this cooling fluid may be a gas. Thus, this cooling gas may, for example, be air, nitrogen gas or carbon dioxide gas. In yet preferred embodiments, this cooling gas may be air. The flowrate of this cooling gas may be configured for enabling fastest cooling in the process space (190) in a minimum amount of time. The flow rate may, in embodiments, be for example, in the range of 400 m³/hour to 600 m³/hour. In embodiments, the flow rate of the cooling gas may be about 500 m³/hour.

It is to be understood that in alternative embodiments, this cooling gas may also comprise a gas mixture suitable for cooling.

## Claims

1. A vertical furnace, comprising:
an inner enclosure (130) defining a process space (150) extending in a vertical direction and an opening for receiving a plurality of wafers,
an outer enclosure (180) surrounding the inner enclosure (130),
a gas injector for injecting a process gas into the process space (190),
an exhaust gas outlet (150) for exhausting the process space (190),
wherein,
a plurality of lamps (110) for heating the plurality of wafers, the lamps (110) being arranged circumferentially in an interior space between the inner enclosure (130) and the outer enclosure (180),
a cooling inlet for providing a cooling fluid into the interior space to cool the interior space,
a plurality of cooling outlets for removing cooling fluid from the interior space, the interior space thus comprising a cooling channel (160), **characterized in that**
said cooling inlet comprises a plurality of cooling inlets that are positioned collinear along the vertical direction of the vertical furnace, or alternatively positioned diagonally to one another along the vertical direction of the vertical furnace, so that upon entry of the cooling fluid in the cooling channel (160) through each of the cooling inlets, the cooling fluid travels circumferentially in the cooling channel (160) before leaving the cooling channel (160) through the plurality of cooling outlets.

2. The vertical furnace according to claim 1, wherein the plurality of cooling outlets is aligned adjacent to the plurality of cooling inlets.

3. The vertical furnace according to claim 1 or 2, further comprising a reflector assembly arranged within the interior space in a vertical direction and formed in a cylindrical shape enclosing the process space (150), the reflector assembly comprising a reflective portion (113) alternatingly arranged with a partially non-reflective portion (111), wherein the reflective portion (113) is formed as pockets (112) protruding from the partially non-reflective portion (111) and extending away from the inner enclosure (130) and wherein each of the lamps (110) is positioned individually inside each of the pockets (112).

4. The vertical furnace according to claim 3, wherein the partially non-reflective portion (111) of the reflector assembly is positioned away from the inner enclosure (130) by a distance in the range of 10 mm - 40 mm, thereby forming a passage for cooling the inner enclosure (130) by flowing the cooling fluid.

5. The vertical furnace according to any one of claims 1-4, wherein the plurality of lamps (110) is positioned at regular intervals from one another circumferentially and are extending along the vertical direction.

6. The vertical furnace according to claim 5, wherein the plurality of lamps (110) is positioned collinear to one another along the vertical direction.

7. The vertical furnace according to claim 5, wherein the plurality of lamps (110) is positioned in a staggered order along the vertical direction.

8. The vertical furnace according to claim 5, wherein the plurality of lamps (110) is positioned diagonally to one another along the vertical direction.

9. The vertical furnace according to claim 3, wherein the reflective portion (113) comprises a reflector facing the lamps (110).

10. The vertical furnace according to claim 9, wherein the reflector comprises a silver alloy or an aluminium alloy.

11. The vertical furnace according to claim 3, wherein the reflector assembly extends along a height corresponding to the height of the process space (150).

12. A method of forming a semiconductor structure comprising a film, the method comprising:
providing a vertical furnace according to any one of claims 1-11,
providing a plurality of wafers arranged in a wafer boat (120),
loading the wafer boat (120) into the process space (150) comprised in a process chamber of the vertical furnace,
heating the process space (150), thereby increasing the temperature up to a predetermined temperature suitable for forming a film,
providing, into the process space (150), a process gas for forming the film on the plurality of wafers at the predetermined temperature, and thereafter;
providing a cooling fluid, in the interior space, for cooling the interior space.

## Patentansprüche

1. Vertikalofen, der Folgendes umfasst:
einen inneren Einschluss (130), der einen Prozessraum (150) definiert, der sich in einer vertikalen Richtung erstreckt, und eine Öffnung zum Aufnehmen einer Vielzahl von Wafern,
einen äußeren Einschluss (180), der den inneren Einschluss (130) umgibt,
einen Gasinjektor zum Einspritzen eines Prozessgases in den Prozessraum (190),
einen Abgasauslass (150) zum Ablassen des Prozessraums (190),
wobei,
eine Vielzahl von Lampen (110) zum Erhitzen der Vielzahl von Wafern, wobei die Lampen (110) umfänglich in einem Innenraum zwischen dem inneren Einschluss (130) und dem äußeren Einschluss (180) eingerichtet sind,
einen Kühleinlass zum Bereitstellen eines Kühlfluids in den Innenraum, um den Innenraum zu kühlen,
eine Vielzahl von Kühlauslässen zum Entfernen von Kühlfluid aus dem Innenraum, so dass der Innenraum einen Kühlkanal (160) umfasst, **dadurch gekennzeichnet, dass**
der Kühleinlass eine Vielzahl von Kühleinlässen umfasst, die kolinear entlang der vertikalen Richtung des Vertikalofens positioniert sind oder alternativ diagonal zueinander entlang der vertikalen Richtung des Vertikalofens derart positioniert sind, dass sich beim Eintritt des Kühlfluids in den Kühlkanal (160) durch jeden der Kühleinlässe das Kühlfluid umfänglich in dem Kühlkanal (160) bewegt, bevor es den Kühlkanal (160) durch die Vielzahl von Kühlauslässen verlässt.

2. Vertikalofen nach Anspruch 1, wobei die Vielzahl von Kühlauslässen an die Vielzahl von Kühleinlässen angrenzend ausgerichtet ist.

3. Vertikalofen nach Anspruch 1 oder 2, der ferner eine Reflektoranordnung umfasst, die innerhalb des Innenraums in einer vertikalen Richtung eingerichtet und in einer zylindrischen Form gebildet ist, die den Prozessraum (150) einschließt, wobei die Reflektoranordnung einen reflektierenden Abschnitt (113) umfasst, der abwechselnd mit einem teilweise nicht reflektierenden Abschnitt (111) eingerichtet ist, wobei der reflektierende Abschnitt (113) als Taschen (112) gebildet ist, die von dem teilweise nicht reflektierenden Abschnitt (111) hervorragen und sich von dem inneren Einschluss (130) weg erstrecken, und wobei jede der Lampen (110) einzeln innerhalb jeder der Taschen (112) positioniert ist.

4. Vertikalofen nach Anspruch 3, wobei der teilweise nicht reflektierende Abschnitt (111) der Reflektoranordnung von dem inneren Einschluss (130) um einen Abstand in dem Bereich von 10 mm - 40 mm weg positioniert ist, wodurch ein Durchgang zum Kühlen des inneren Einschlusses (130) durch Strömen des Kühlfluids gebildet wird.

5. Vertikalofen nach einem der Ansprüche 1 bis 4, wobei die Vielzahl von Lampen (110) in regelmäßigen Abständen voneinander umfänglich positioniert sind und sich entlang der vertikalen Richtung erstrecken.

6. Vertikalofen nach Anspruch 5, wobei die Vielzahl von Lampen (110) kolinear zueinander entlang der vertikalen Richtung positioniert ist.

7. Vertikalofen nach Anspruch 5, wobei die Vielzahl von Lampen (110) in einer gestaffelten Reihenfolge entlang der vertikalen Richtung positioniert ist.

8. Vertikalofen nach Anspruch 5, wobei die Vielzahl von Lampen (110) diagonal zueinander entlang der vertikalen Richtung positioniert ist.

9. Vertikalofen nach Anspruch 3, wobei der reflektierende Abschnitt (113) einen Reflektor, der den Lampen (110) zugewandt ist, umfasst.

10. Vertikalofen nach Anspruch 9, wobei der Reflektor eine Silberlegierung oder eine Aluminiumlegierung umfasst.

11. Vertikalofen nach Anspruch 3, wobei sich die Reflektoranordnung entlang einer Höhe, die der Höhe des Prozessraums (150) entspricht, erstreckt.

12. Verfahren zum Bilden eines Halbleiteraufbaus der einen Film aufweist, das Folgendes umfasst:
Bereitstellen eines Vertikalofens nach einem der Ansprüche 1 bis 11, Bereitstellen einer Vielzahl von Wafern, die in einem Wafer-Boat (120) eingerichtet sind,
Laden des Wafer-Boats (120) in den Prozessraum (150), der in einer Prozesskammer des Vertikalofens enthalten ist,
Heizen des Prozessraums (150), wodurch die Temperatur bis zu einer vorbestimmten Temperatur erhöht wird, die zum Bilden eines Films geeignet ist,
Bereitstellen eines Prozessgases in dem Prozessraum (150) zum Bilden des Films auf der Vielzahl von Wafern bei einer vorbestimmten Temperatur und danach;
Bereitstellen eines Kühlfluids in dem Innenraum zum Kühlen des Innenraums.

## Revendications

1. Four vertical comprenant :
une enceinte interne (130) définissant un espace de traitement (150) s'étendant dans une direction verticale et une ouverture pour recevoir une pluralité de plaquettes,
une enceinte externe (180) entourant l'enceinte interne (130),
un injecteur de gaz pour injecter un gaz de traitement dans l'espace de traitement (190),
une sortie de gaz d'échappement (150) pour évacuer l'espace de traitement (190),
dans lequel :
une pluralité de lampes (110) pour chauffer la pluralité de plaquettes, les lampes (110) étant agencées, de manière circonférentielle, dans un espace intérieur entre l'enceinte interne (130) et l'enceinte externe (180),
une entrée de refroidissement pour fournir un fluide de refroidissement dans l'espace intérieur afin de refroidir l'espace intérieur,
une pluralité de sorties de refroidissement pour retirer le fluide de refroidissement de l'espace intérieur, l'espace intérieur comprenant ainsi un canal de refroidissement (160), **caractérisé en ce que** :
ladite entrée de refroidissement comprend une pluralité d'entrées de refroidissement qui sont positionnées, de manière colinéaire, le long de la direction verticale du four vertical, ou bien positionnées, de manière alternée, en diagonale les unes par rapport aux autres le long de la direction verticale du four vertical, de sorte que suite à l'entrée du fluide de refroidissement dans le canal de refroidissement (160) à travers chacune des entrées de refroidissement, le fluide de refroidissement se déplace, de manière circonférentielle, dans le canal de refroidissement (160) avant de sortir du canal de refroidissement (160) par la pluralité de sorties de refroidissement.

2. Four vertical selon la revendication 1, dans lequel la pluralité de sorties de refroidissement est alignée de manière adjacente à la pluralité d'entrées de refroidissement.

3. Four vertical selon la revendication 1 ou 2, comprenant en outre un ensemble de réflecteur agencé dans l'espace intérieur dans une direction verticale et formé dans une forme cylindrique enfermant l'espace de traitement (150), l'ensemble de réflecteur comprenant une partie réfléchissante (113) agencée, de manière alternée, avec une partie partiellement non réfléchissante (111), dans lequel la partie réfléchissante (113) est formée comme des poches (112) qui font saillie de la partie partiellement non réfléchissante (111) et s'étendant à l'opposé de l'enceinte interne (130) et dans lequel chacune des lampes (110) est positionnée individuellement à l'intérieur de chacune des poches (112).

4. Four vertical selon la revendication 3, dans lequel la partie partiellement non réfléchissante (111) de l'ensemble de réflecteur est positionnée à l'opposé de l'enceinte interne (130) selon une distance dans la plage de 10 mm à 40 mm, formant ainsi un passage pour refroidir l'enceinte interne (130) pour laisser s'écouler le fluide de refroidissement.

5. Four vertical selon l'une quelconque des revendications 1 à 4, dans lequel la pluralité de lampes (110) est positionnée à intervalles réguliers les unes des autres de manière circonférentielle et s'étendent le long de la direction verticale.

6. Four vertical selon la revendication 5, dans lequel la pluralité de lampes (110) sont positionnées de manière colinéaire les unes par rapport aux autres le long de la direction verticale.

7. Four vertical selon la revendication 5, dans lequel la pluralité de lampes (110) sont positionnées dans un ordre en quinconce le long de la direction verticale.

8. Four vertical selon la revendication 5, dans lequel la pluralité de lampes (110) sont positionnées, en diagonale les unes par rapport aux autres, le long de la direction verticale.

9. Four vertical selon la revendication 3, dans lequel la partie réfléchissante (113) comprend un réflecteur faisant face aux lampes (110).

10. Four vertical selon la revendication 9, dans lequel le réflecteur comprend un alliage d'argent ou un alliage d'aluminium.

11. Four vertical selon la revendication 3, dans lequel l'ensemble de réflecteur s'étend le long d'une hauteur correspondant à la hauteur de l'espace de traitement (150).

12. Procédé pour former une structure semi-conductrice comprenant un film, le procédé comprenant les faits de :
prévoir un four vertical selon l'une quelconque des revendications 1 à 11,
prévoir une pluralité de plaquettes agencées dans une nacelle de plaquettes (120),
charger la nacelle de plaquettes (120) dans l'espace de traitement (150) compris dans une chambre de traitement du four vertical,
chauffer l'espace de traitement (150), augmentant ainsi la température jusqu'à une température prédéterminée appropriée pour former un film,
prévoir, dans l'espace de traitement (150), un gaz de traitement pour former le film sur la pluralité de plaquettes à la température prédéterminée ; et ensuite
prévoir un fluide de refroidissement, dans l'espace intérieur, pour refroidir l'espace intérieur.
